# EUROPÄISCHE PATENTSCHRIFT

(11) **EP 3 716 409 B1**
(45) Veröffentlichungstag und Bekanntmachung des Hinweises auf die Patenterteilung: **09.09.2026**
(21) Anmeldenummer: 20166242.6
(22) Anmeldetag: 27.03.2020
(51) Int. Cl.: H01R 12/70, H01R 12/71, G01R 31/28

(54) **KONTAKTOR, KONTAKTORSYSTEM UND VERFAHREN ZUM ELEKTRISCHEN KONTAKTIEREN EINER LEITERPLATTE UND/ODER EINES MODULS**
CONTACTOR, CONTACTOR SYSTEM AND METHOD FOR ELECTRICALLY CONTACTING A CIRCUIT BOARD AND/OR A MODULE
CONTACTEUR, SYSTÈME DE CONTACTEUR ET PROCÉDÉ DE CONTACTE ÉLECTRIQUE D'UNE CARTE DE CIRCUIT IMPRIMÉ ET/OU D'UN MODULE

(30) Priorität: 28.03.2019 DE 102019002275
(43) Veröffentlichungstag der Anmeldung: 30.09.2020
(73) Patentinhaber: Yamaichi Electronics Deutschland GmbH, 85609 Aschheim-Dornach (DE)
(72) Erfinder: BTAHRI, Jemei, 4000 Sousse (TN); QUITER, Michael, 57482 Wenden (DE); SERNA, Yoann, 6511 Zams (AT)
(74) Vertreter: Müller-Boré & Partner Patentanwälte PartG mbB

(56) Entgegenhaltungen:
- EP-A1- 1 220 592
- DD-A1- 215 867
- DE-A1- 102006 022 330
- JP-A- H06 177 557
- US-A- 4 647 852
- US-B1- 8 057 248

## Beschreibung

Die Erfindung betrifft einen Kontaktor, ein Kontaktsystem und ein Verfahren zum elektrischen Kontaktieren einer Leiterplatte und/oder eines Moduls.

Herkömmlich werden Steckverbinder benutzt, um elektrische Kontakte zwischen einer Leiterplatte und/oder einem Modul einerseits und einem elektrischen Gerät, z.B. einem mehradrigen Kabel und/oder einem Prozessor, andererseits herzustellen. Abhängig von der verwendeten Busgröße und/oder Busart gibt es dazu eine Mehrzahl vorbekannter, herkömmlicher Steckverbindertypen.

Die Erfindung stellt eine neue Möglichkeit zum elektrischen Kontaktieren einer Leiterplatte und/oder einem Modul bereit. Dabei kann die Leiterplatte z.B. als eine PCB ausgebildet sein, was als Abkürzung für Printed Circuit Board steht. Das Modul kann z.B. eine Leiterplatte aufweisen. Dabei soll eine elektrische Kontaktierung von z.B. offenen Kontakten der Leiterplatte und/oder des Moduls ermöglicht werden.

Die neue Kontaktmöglichkeit kann z.B. dazu verwendet werden, um Leiterplatten und/oder Module in einer Zusammenwirkung zu testen. Weiterhin kann die neue Kontaktmöglichkeit genutzt werden, um ein Software-Update auf ein bereits vorhandenes elektronisches Bauteil einzuspielen, welches mittels eines ganz bestimmten, individuellen Adapters kontaktiert werden kann. Dabei kann es ein Ziel der Erfindung sein, mittels eines individuellen Kontaktors eine alternative Verbindungsmöglichkeit bereitzustellen, ohne eine Kontaktierung mittels einer herkömmlichen Steckverbindung zu erlauben.

Das Dokument EP 1 220 592 A1 offenbart ein Verbindungsmittel, welches dazu ausgebildet ist, durch zueinander ausgerichtete Öffnungen zweier Komponenten hindurch montiert zu werden. Das Verbindungsmittel weist ein Säulenelement auf, das durch eine Öffnung einer Komponente montiert werden kann und das eine axiale Richtung des Verbindungsmittels definiert. Ein Federmittel ist so angeordnet, dass es eine Druckkraft in axialer Richtung ausübt. Ein erstes Mittel nimmt die Federmittel in axialer Richtung auf und ein zweites Mittel sichert die Montage des Verbindungsmittels ab.

Das Dokument DE 10 2006 022330 A1 offenbart ein Modul zur elektrischen Kontaktierung von Leiterplatten, mit dem elektrische Signale von außen in die Leiterbahnen der Leiterplatte eingespeist und wieder ausgelesen werden können. Das erfolgt durch ein Modul zur elektrischen Kontaktierung von Leiterplatten mit Testpunkten, wobei die Testpunkte in Form eines Musters bezüglich mindestens eines in der Leiterplatte befindlichen Durchbruches angeordnet sind. Dabei weist mindestens ein Testpunkt, der so genannte Referenztestpunkt, eine andere geometrische Ausdehnung als die übrigen Testpunkte auf. Das Modul weist einen Arretierungsmechanismus auf, der über die Dauer der Kontaktierung das Modul unter Nutzung des Durchbruches fest auf der Leiterplatte arretiert. Das Modul weist ferner Kontaktflächen auf, wobei im arretierten Zustand des Moduls jeder Testpunkt mit mindestens einer Kontaktfläche in Verbindung steht und jede Kontaktfläche mit einer Signalleitung verbunden ist, die die Verbindung zwischen Testmodul und Testsystem herstellt.

Allgemein ist es die Aufgabe der Erfindung, eine alternative Möglichkeit zum elektrischen Kontaktieren einer Leiterplatte und/oder eines Moduls zu ermöglichen.

Diese Aufgabe wird durch die Gegenstände der unabhängigen Ansprüche gelöst. Ausführungsformen sind die Gegenstände der abhängigen Ansprüche.

Ein Aspekt betrifft einen Kontaktor zum elektrischen Kontaktieren einer Leiterplatte und/oder eines Moduls mit einem Kontaktorkörper, welcher eine Kontaktfläche mit elektrischen Kontaktelementen aufweist. Der Kontaktor weist weiterhin zumindest zwei über die Kontaktfläche in eine Kontaktrichtung hervorstehende Formschlussmittel zum Eingehen einer formschlüssigen Verbindung mit der Leiterplatte und/oder dem Modul auf und ein Schraubmittel. Dabei ist die Kontaktfläche dazu konfiguriert und ausgebildet, in Kontaktrichtung einen mechanischen Kontakt mit einer Anschlussfläche der Leiterplatte und/oder des Moduls derart einzugehen, dass die elektrischen Kontaktelemente der Kontaktfläche dazu korrespondierende elektrische Kontakte der Leiterplatte und/oder des Moduls elektrisch kontaktieren. Die Formschlussmittel sind relativ zur Kontaktfläche beweglich an den Kontaktor gelagert. Sämtliche Formschlussmittel sind so aneinander und/oder an das Schraubmittel gekoppelt, dass sie durch Betätigung des Schraubmittels synchron zueinander relativ zur Kontaktfläche verlagerbar sind.

Der Kontaktorkörper kann ein Kontaktorgehäuse aufweisen und/oder als ein Kontaktorgehäuse ausgebildet sein. Dabei kann die Kontaktfläche als eine Außenfläche des Kontaktorkörpers ausgebildet sein. Die Kontaktfläche kann insbesondere als eine Außenfläche des Kontaktorkörpers ausgebildet sein, welche in Kontaktrichtung von dem Kontaktor weg weist. Hierbei kann die Kontaktrichtung parallel zu einer Normalen auf die Kontaktfläche ausgerichtet sein. An der Kontaktfläche sind Enden der elektrischen Kontaktelemente des Kontaktors angeordnet, welche an der Kontaktfläche in elektrischen Kontakt mit den elektrischen Kontakten der Leiterplatte und/oder des Moduls treten können. Die elektrischen Kontakte können im Inneren des Kontaktorkörpers verlegt sein und den Kontaktorkörper zumindest teilweise durchdringen, insbesondere bis zu einer zweiten Außenfläche des Kontaktorkörpers, an welcher z.B. ein herkömmlicher Steckverbinder angeordnet sein kann, eine Leiterplatte und/oder ein anderes elektrisches Modul.

Die zumindest zwei Formschlussmittel stehen über die Kontaktfläche in Kontaktrichtung hervor. Dabei weist der Kontaktor mehrere Formschlussmittel auf, besonders bevorzugt genau zwei Formschlussmittel. Die Verwendung zweier hervorstehender Formschlussmittel ermöglicht eine unverwechselbare Ausrichtung des Kontaktors relativ zur Leiterplatte und/oder dem Modul.

Die Formschlussmittel können stiftartig ausgebildet sein, insbesondere zumindest abschnittsweise stiftartig. Die Formschlussmittel können im Wesentlichen zylinderförmig ausgebildet sein, wobei die Zylinderachse parallel zur Kontaktrichtung ausgebildet sein kann. Mit anderen Worten können die Formschlussmittel im Wesentlichen vollständig stiftartig ausgebildet sein. Die stiftartige Ausbildung ermöglicht einerseits ein einfaches und/oder sicheres Einführen des Formschlussmittels in die Leiterplatte und/oder das Modul, andererseits eine einfache Verlagerung der Formschlussmittel relativ zur Kontaktfläche, nämlich in Zylinderachsenrichtung des Formschlussmittels.

Die Formschlussmittel sind zumindest relativ zur Kontaktfläche beweglich an und/oder in dem Kontaktor gelagert, bevorzugt auch beweglich relativ zum Kontaktorkörper. Mit anderen Worten sind die Formschlussmittel zumindest relativ zur Kontaktfläche verlagerbar. Der Kontaktor kann zumindest ein Federmittel aufweisen, so dass die Formschlussmittel rückstellfähig gegen die Kraft des Federmittels verlagerbar sind. Die verlagerbare Ausgestaltung der Formschlussmittels ermöglicht es, eine individuelle mechanische Verbindung zwischen dem Kontaktor einerseits und der Leiterplatte und/oder dem Modul andererseits auszubilden. Dies ermöglicht es, einen individuell geformten und/oder ausgebildeten Kontaktor bereitzustellen, der sich von herkömmlichen Steckverbindern unterscheidet. Damit wird eine Möglichkeit bereitgestellt, es z.B. nur dem oder den Besitzer(n) des individuell gestalteten Kontaktors zu erlauben, die Leiterplatte und/oder das Modul elektrisch zu kontaktieren.

Die formschlüssige Verbindung der Formschlussmittel mit der Leiterplatte und/oder dem Modul kann einerseits als ein Formschluss in zumindest eine erste Richtung wirken, z.B. in eine Richtung etwa orthogonal zur Kontaktrichtung. Dieser erste Formschluss kann beim Einführen des z.B. länglichen Formschlussmittels in Kontaktrichtung in entsprechende Aussparungen der Leiterplatte und/oder des Moduls bereitgestellt werden. Andererseits kann die Verbindung auch einen Formschluss in eine zweite Richtung umfassen, z.B. einen Formschluss parallel zur Kontaktrichtung. Durch diesen Formschluss parallel zur Kontaktrichtung kann verhindert werden, dass sich die mechanische Verbindung zwischen dem Kontaktor einerseits und der Leiterplatte und/oder dem Modul andererseits durch ein unbeabsichtigtes Herausbewegen des Formschlussmittels aus der Leiterplatte und/oder dem Modul unbeabsichtigt löst.

Bevorzugt wirkt der letztendlich bereitgestellte Formschluss in sämtliche Raumrichtungen, insbesondere in und gegen die Kontaktrichtung sowie in vier Orthogonalrichtungen, von denen jede orthogonal zur Kontaktrichtung sowie orthogonal zu zwei der übrigen Orthogonalrichtungen angeordnet ist.

Damit wird eine individuell designte und sichere Verbindung ermöglicht.

In einer Ausführungsform sind die Formschlussmittel relativ zur Kontaktfläche und/oder zum Kontaktorkörper in Kontaktrichtung beweglich ausgebildet. Dies bedeutet, dass die Formschlussmittel parallel zur Kontaktrichtung, also in und/oder gegen die Kontaktrichtung, verlagerbar am Kontaktor gelagert sind. Dafür können die Formschlussmittel etwa länglich ausgebildet sein, z.B. stiftartig, wobei sie insbesondere in die Richtung seiner längsten Ausdehnung, also z.B. in Zylinderachsenrichtung, verlagerbar am Kontaktor gelagert sein kann. Die Beweglichkeit der Formschlussmittel parallel zur Kontaktrichtung auszubilden, also in genau die Richtung, in welcher die Kontaktfläche des Kontaktors auf die Anschlussfläche der Leiterplatte und/oder des Moduls aufgelegt werden, erweist sich dabei als besonders geeignet zum Bereitstellen einer zumindest formschlüssigen Verbindung zwischen dem Kontaktor einerseits und der Leiterplatte und/oder dem Modul andererseits. Dabei kann ein Einführen der Formschlussmittel in die Leiterplatte und/oder das Modul praktischerweise in genau die Richtung erfolgen, in welcher auch die Kontaktfläche auf die Anschlussfläche gelegt wird.

Gemäß einer Ausführungsform sind die Formschlussmittel in einer Führungsausnehmung durch den Kontaktorkörper beweglich gelagert. Die Führungsausnehmung kann den Kontaktorkörper dabei im Wesentlichen vollständig durchdringen. Bevorzugt durchdringt die Führungsausnehmung zumindest einen kompakten Teil des Kontaktorkörpers vollständig. Die Lagerung im Inneren der Führungsausnehmung schützt die Anbindung des jeweiligen Formschlussmittels an den Kontaktor besonders gut und ermöglicht zudem eine stabile Führung und/oder Eingrenzung eines Bewegungsspielraums des Formschlussmittels relativ zum Kontaktorkörper.

Gemäß einer Ausführungsform weisen die Formschlussmittel jeweils einen Einsteckbereich auf, der jeweils dazu ausgebildet ist, in eine Formschlussmittelaufnahme der Leiterplatte und/oder des Moduls einzugreifen. Der Einsteckbereich kann etwa dem Bereich des Formschlussmittels entsprechen, welches z.B. in einem entspannten und/oder geschlossenen Zustand des Kontaktors über die Kontaktfläche heraussteht. Dabei kann der Einsteckbereich als ein Stiftabschnitt ausgebildet sein, der über die Kontaktfläche hervorsteht. Dabei ist dieser Stiftabschnitt des Formschlussmittels dazu ausgebildet, in die Formschlussmittelaufnahme der Leiterplatte und/oder des Moduls einzugreifen. Vorzugsweise greift der Einsteckbereich in Kontaktrichtung in die Formschlussmittelaufnahme der Leiterplatte und/oder des Moduls ein. Deswegen kann die Formschlussmittelaufnahme z.B. hohlzylinderförmig ausgebildet sein, wobei eine Hohlzylinderachse der Formschlussmittelaufnahme in etwa parallel zur Kontaktrichtung ausgebildet sein kann. Eine Innendimensionierung der Formschlussmittelaufnahme kann dabei auf eine Außendimensionierung des Einsteckbereichs abgestimmt sein. Die Innendimensionierung der Formschlussmittelaufnahme und die Außendimensionierung des Einsteckbereichs kann dabei ein Einstecken des Einstecksbereichs in die Formschlussmittelaufnahme unter vordefinierten Bewegungsspielen ermöglichen.

In einer Weiterbildung dieser Ausführungsform weisen die Formschlussmittel am Einsteckbereich einen Lateralsteg auf, welcher etwa orthogonal zur Kontaktrichtung ausgebildet ist. Der Lateralsteg kann als eine Art Widerhaken und/oder Vorsprung ausgebildet sein, um die formschlüssige Befestigung des Kontaktors an der Leiterplatte und/oder dem Modul zu unterstützen und/oder zu verstärken. Mit anderen Worten kann der Einsteckbereich zumindest einen ersten Ausdehnungsbereich und/oder Ausdehnungsabschnitt aufweisen, der etwa parallel zur Kontaktrichtung ausgebildet ist, während der Lateralsteg als ein zweiter Ausdehnungsbereich und/oder Ausdehnungsabschnitt des Einsteckbereichs in etwa orthogonal dazu ausgebildet ist.

In einer Weiterbildung dieser Ausführungsform ist der Lateralsteg dazu ausgebildet, eine dem Kontaktor abgewandte Auflagefläche an der Formschlussmittelaufnahme der Leiterplatte und/oder des Moduls zu hintergreifen. Hierbei kann die Formschlussmittelaufnahme beispielsweise als ein Bohrloch durch die Leiterplatte ausgebildet sein. Bei der Montage wird das Formschlussmittel, genauer der Einsteckbereich des Formschlussmittels, in die Formschlussmittelaufnahme hineingesteckt, z.B. durch die Leiterplatte hindurch. Anschließend kann das Formschlussmittel etwa orthogonal zur Kontaktrichtung verlagert werden, so dass der Lateralsteg eine dem Kontaktor abgewandte Seite der Leiterplatte hintergreift und/oder an ihr anliegt. Dabei kann die Auflagefläche als ein Abschnitt einer Rückseite der Leiterplatte ausgebildet sein. Alternativ dazu kann die Auflagefläche als ein Haken, ein Vorsprung, und/oder ein anderes Befestigungsmittel der Leiterplatte und/oder des Moduls ausgebildet sein. Der Lateralsteg kann somit dazu konfiguriert sein, einen Formschluss in eine Richtung parallel zur Kontaktrichtung auszubilden.

Gemäß einer Ausführungsform sind die Formschlussmittel dazu ausgebildet, eine formschlüssige Verbindung mit der Leiterplatte und/oder dem Modul derart einzugehen, dass durch Verlagerung des Formschlussmittels relativ zur Kontaktfläche eine kraftschlüssige Verbindung zwischen der Kontaktfläche und der Anschlussfläche der Leiterplatte und/oder des Moduls bereitgestellt wird. Hierbei wird nicht nur eine formschlüssige Befestigung, sondern zusätzlich noch eine kraftschlüssige Verbindung zwischen dem Kontaktor einerseits und der Leiterplatte und/oder dem Modul andererseits bereitgestellt. Die Formschlussmittel können hierbei so konfiguriert sein, dass die Leiterplatte und/oder das Modul aufgrund der Verlagerungsbewegung von den Formschlussmitteln gegen die Auflagefläche gedrückt wird, so dass die kraftschlüssige Verbindung bereitgestellt wird. Hierbei dient die Verlagerung der Formschlussmittel relativ zur Kontaktfläche dazu, die Kontaktfläche des Kontaktors an die Anschlussfläche der Leiterplatte und/oder des Moduls anzudrücken. Hierbei wird eine besonders stabile elektrische und mechanische Verbindung zwischen dem Kontaktor der Leiterplatte und/oder dem Modul ermöglicht.

Gemäß einer Ausführungsform weist der Kontaktor zumindest einen Führungspin auf, welcher in Kontaktrichtung über die Kontaktfläche hervorsteht. Der Führungspin kann dabei zum Eingriff in eine Führungspinaufnahme der Leiterplatte und/oder des Moduls ausgebildet sein. Der Führungspin kann bei der Montage mehrere Aufgaben erfüllen und/oder Wirkungen aufweisen. So kann der Führungspin bei der Montage zum Ausrichten des Kontaktors relativ zur Leiterplatte und/oder zum Modul konfiguriert sein. Der Führungspin kann aus der Kontaktfläche und/oder benachbart hierzu vom Kontaktorkörper abstehen. Insbesondere kann der Führungspin in Kontaktrichtung länglich und/oder stiftartig vom Kontaktorkörper abstehend ausgebildet sein.

In einer Weiterbildung dieser Ausführungsform stehen die Formschlussmittel in Kontaktrichtung weiter über die Kontaktfläche hervor als der Führungspin. Dabei können die Formschlussmittel und/oder der Führungspin entweder unmittelbar aus der Kontaktfläche hervorstehen, oder benachbart hierzu so aus dem Kontaktorkörper hervorstehen, dass die Ebene, in welcher die Kontaktfläche liegt, sowohl von den Formschlussmitteln als auch vom Führungspin in Kontaktrichtung durchstoßen wird. Dabei ragen die Formschlussmittel weiter über die Kontaktfläche heraus als der Führungspin.

Allgemein kann der Kontaktor auch mehr als einen Führungspin aufweisen, insbesondere z.B. genau zwei Führungspins, welche eine sinnvolle und unvertauschbare Anordnung des Kontaktors relativ zum Modul und/oder der Leitungsplatte ermöglichen.

In einer Weiterbildung der Ausführungsform ist der Führungspin derart konfiguriert, dass der Führungspin beim Herstellen einer elektrischen Kontaktierung zwischen dem Kontaktor einerseits und der Leiterplatte und/oder dem Modul andererseits in einer ersten Montageposition als ein Anschlag, insbesondere als ein Anschlag in Kontaktrichtung, wirkt, und der Führungspin in einer zweiten Montageposition unter Eingriff in zumindest eine Führungspinaufnahme der Leiterplatte und/oder des Moduls eine vorbestimmte Positionierung des Kontaktors relativ zur Leiterplatte und/oder dem Modul unterstützt. Zwischen diesen beiden Funktionen, also einmal zwischen der Anschlagsfunktion und der Führungsfunktion, kann bei der Montage eine Verlagerungsbewegung des Kontaktors in etwa orthogonal zur Kontaktrichtung erfolgen, also eine Verlagerung des Kontaktors relativ zur Leiterplatte und/oder dem Modul. Die Nutzung des Führungspins für zumindest zwei unterschiedliche Funktionen macht dessen Verwendung besonders effizient und hilfreich bei der Herstellung des Kontaktes zwischen dem Kontaktor einerseits und der Leiterplatte und/oder dem Modul andererseits.

Dabei sind die Formschlussmittel so konfiguriert, dass sie durch Betätigung eines Schraubmittels des Kontaktors relativ zur Kontaktfläche verlagerbar ist. Das Schraubmittel kann dabei als eine Art Rändelschraube ausgebildet sein und/oder diese aufweisen, mittels derer das Formschlussmittel verlagerbar ist. So kann eine Drehung des Schraubmittels umgesetzt werden in eine Verlagerung der Formschlussmittel, insbesondere in eine Verlagerung der Formschlussmittel relativ zur Kontaktfläche in Kontaktrichtung. Die Verwendung des Schraubmittels zum Verlagern der Formschlussmittel stellt eine besonders günstige, genaue und vergleichsweise einfach zu bedienende Möglichkeit bereit, die Formschlussmittel zu verlagern und/oder zu betätigen. Hierbei sind bevorzugt sämtliche Formschlussmittel des Kontaktors aneinander und/oder an ein einziges Schraubmittel des Kontaktors so gekoppelt, so dass sie sich bei Betätigung des Schraubmittels synchron zueinander relativ zur Kontaktfläche bewegen.

Gemäß einer Ausführungsform sind die Formschlussmittel derart konfiguriert, dass der Kontaktor durch eine Bewegung des Kontaktors relativ zur Leiterplatte und/oder zum Modul in etwa in Kontaktrichtung in eine erste Montageposition bringbar ist, in welcher die Formschlussmittel in eine Formschlussmittelaufnahme der Leiterplatte und/oder des Moduls eingreifen. Hierzu weisen die Formschlussmittel bevorzugt eine Ausdehnung in Kontaktrichtung auf, beispielsweise einen Eingriffsbereich. Die Formschlussmittelaufnahme weist einen Aufnahmebereich mit einer Ausdehnung ebenfalls in Kontaktrichtung auf, in welchen das Formschlussmittel zumindest teilweise eingreift. In der ersten Montageposition kann dabei ein Formschluss in eine oder sämtliche Raumrichtung(en) orthogonal zur Kontaktrichtung wirken, während zumindest gegen die Kontaktrichtung noch kein Formschluss wirkt. In Kontaktrichtung kann ebenfalls bereits ein Formschluss wirken.

In einer Weiterbildung dieser Ausführungsform sind die Formschlussmittel derart konfiguriert, dass der Kontaktor durch eine Bewegung des Kontaktors relativ zur Leiterplatte und/oder zum Modul in etwa orthogonal zur Kontaktrichtung von der ersten Montageposition in eine zweite Montageposition bringbar ist, in welcher die Formschlussmittel (weiterhin) in die Formschlussmittelaufnahme der Leiterplatte und/oder des Moduls eingreifen. Diese Bewegung von der ersten Montageposition in die zweite Montageposition erfolgt etwa orthogonal zur Kontaktrichtung. Dies kann dadurch ermöglicht werden, dass an den Formschlussmitteln lateral eine Aussparung ausgebildet ist, in welcher ein Vorsprung der Formschlussmittelaufnahme etwa orthogonal zur Kontaktrichtung eingreift. In der zweiten Montageposition kann der Formschluss sowohl orthogonal als auch parallel zur Kontaktrichtung wirken. Dabei kann der Formschluss in der zweiten Montageposition so ausgebildet sein, dass er (ein) vorbestimmte(s) Bewegungsspiel(e) des Kontaktors relativ zur Leiterplatte und/oder dem Modul in mehrere Richtungen zulässt.

In einer Weiterbildung dieser Ausführungsform sind die Formschlussmittel derart konfiguriert, dass der Kontaktor durch eine Bewegung des Kontaktors relativ zur Leiterplatte und/oder zum Modul in etwa in Kontaktrichtung von der zweiten Montageposition in eine dritte Montageposition bringbar ist, in welcher die Formschlussmittel (z.B. weiterhin) in die Formschlussmittelaufnahme der Leiterplatte und/oder des Moduls eingreifen, und in welcher die Kontaktfläche des Kontaktors auf der Anschlussfläche der Leiterplatte und/oder des Moduls aufliegt. Mit anderen Worten kann der Kontaktor hierbei in Kontaktrichtung soweit auf die Leiterplatte und/oder das Modul zu bewegt werden, bis die Kontaktfläche des Kontaktors auf der Anschlussfläche der Leiterplatte und/oder des Moduls aufliegt. In der dritten Montageposition kann ein Formschluss parallel und orthogonal zur Kontaktrichtung wirken, während die Verbindung in der dritten Montageposition noch kraftschlussfrei ausgebildet sein kann. Der Formschluss in der dritten Montageposition kann so ausgebildet sein, dass er (ein) vorbestimmte(s) Bewegungsspiel(e) des Kontaktors relativ zur Leiterplatte und/oder dem Modul in mehrere Richtungen zulässt.

In einer Weiterbildung dieser Ausführungsform sind die Formschlussmittel derart konfiguriert, dass der Kontaktor durch eine Bewegung der Formschlussmittel relativ zur Kontaktfläche in etwa gegen die Kontaktrichtung von der dritten Montageposition in eine vierte Montageposition bringbar, also überführbar, ist, in welcher:
- die Formschlussmittel (z.B. weiterhin) in die Formschlussmittelaufnahme der Leiterplatte und/oder des Moduls eingreifen,
- die Kontaktfläche des Kontaktors (z.B. weiterhin) auf der Anschlussfläche der Leiterplatte und/oder des Moduls aufliegt,
- die elektrischen Kontaktelemente der Kontaktfläche dazu korrespondierende elektrische Kontakte der Leiterplatte und/oder des Moduls elektrisch kontaktieren und
- der Kontaktor sowohl formschlüssig als auch kraftschlüssig mit der Leiterplatte und/oder dem Modul verbunden ist.

Die Verbindung wird von der dritten in die vierte Montageposition überführt, in dem die zumindest zwei Formschlussmittel relativ zur Kontaktfläche verlagert werden, z.B. indem sie eingefahren werden in Richtung ins Innere des Kontaktorkörpers hinein. Die Verlagerungsbewegung kann hierbei eine Verlagerung der Formschlussmittel in etwa parallel zur und gegen die Kontaktrichtung sein und ins Innere des Kontaktorkörpers weisen. Durch den parallel zur Kontaktrichtung wirkenden Formschluss wird dabei die Leiterplatte und/oder das Modul auf die Kontaktfläche des Kontaktors (und/oder umgekehrt) gedrückt. Dabei wird eine besonders stabile Verbindung zwischen dem Kontaktor einerseits und der Leiterplatte und/oder dem Modul andererseits bereitgestellt, welche sich von einer herkömmlichen Steckverbindung unterscheidet.

Ein Aspekt betrifft ein Kontaktorsystem mit einem Kontaktor gemäß dem eingangs beschriebenen Aspekt und einer Leiterplatte und/oder einem Modul mit zumindest einer Formschlussmittelaufnahme zur Aufnahme des zumindest einen Formschlussmittels des Kontaktors derart, dass der Kontaktor mit der Leiterplatte und/oder dem Modul so verbunden ist, dass die elektrischen Kontaktelemente der Kontaktfläche die dazu korrespondierenden elektrischen Kontakte der Leitplatte und/oder des Moduls elektrisch kontaktieren. Hierbei umfasst das Kontaktorsystem sowohl den Kontaktor nach dem vorangegangenen Aspekt als auch die zugehörige Leiterplatte und/oder das zugehörige Modul mit der zumindest einen, zur Aufnahme des Formschlussmittels konfigurierten, Formschlussmittelaufnahme.

Ein Aspekt betrifft ein Verfahren zum elektrischen Kontaktieren einer Leiterplatte und/oder eines Moduls mit den Schritten:
- Bereitstellen eines Kontaktors mit einem Kontaktorkörper, welcher eine Kontaktfläche mit elektrischen Kontaktelementen aufweist, und mit einem Schraubmittel;
- Bewegen eines Formschlussmittels des Kontaktors, welches in eine Kontaktrichtung über die Kontaktfläche hervorsteht, relativ zur Kontaktfläche derart, dass der Kontaktor eine formschlüssige Verbindung mit der Leiterplatte und/oder dem Modul eingeht;
wobei
- die Kontaktfläche in Kontaktrichtung einen mechanischen Kontakt mit einer Anschlussfläche der Leiterplatte und/oder des Moduls derart eingeht, dass die elektrischen Kontaktelemente der Kontaktfläche dazu korrespondierende elektrische Kontakte der Leiterplatte und/oder des Moduls elektrisch kontaktieren und
- Koppeln sämtlicher Formschlussmittel so aneinander und/oder an das Schraubmittel, dass sie durch Betätigung des Schraubmittels synchron zueinander relativ zur Kontaktfläche verlagert werden.

Das Verfahren kann zum Beispiel mittels eines Kontaktors gemäß dem eingangs beschriebenen Aspekt durchgeführt werden. Deswegen betreffen sämtliche Ausführungen zu dem Kontaktor auch das Verfahren und umgekehrt.

In einer Weiterbildung weist das Verfahren die Schritte auf:
- Bewegen des Kontaktors relativ zur Leitplatte und/oder zum Modul in eine erste Montageposition in etwa in Kontaktrichtung derart, dass die Formschlussmittel in eine Formschlussmittelaufnahme der Leiterplatte und/oder des Moduls eingreifen;
- Bewegen des Kontaktors relativ zur Leiterplatte und/oder zum Modul in etwa orthogonal zur Kontaktrichtung von der ersten Montageposition in eine zweite Montageposition, wobei die Formschlussmittel weiterhin in die Formschlussmittelaufnahme der Leiterplatte und/oder des Moduls eingreifen;
- Bewegen des Kontaktors relativ zur Leiterplatte und/oder zum Modul in etwa in Kontaktrichtung von der zweiten Montageposition in eine dritte Montageposition, wobei die Formschlussmittel weiterhin in die Formschlussmittelaufnahme der Leiterplatte und/oder des Moduls eingreifen und soweit bis die Kontaktfläche des Kontaktors auf der Anschlussfläche der Leiterplatte und/oder des Moduls aufliegt; und
- Bewegen der Formschlussmittel relativ zur Kontaktfläche in etwa gegen die Kontaktrichtung von der dritten Montageposition in eine vierte Montageposition, wobei
   - die Formschlussmittel weiterhin in die Formschlussmittelaufnahme der Leiterplatte und/oder des Moduls eingreifen,
   - die Kontaktfläche des Kontaktors weiterhin auf der Anschlussfläche der Leiterplatte und/oder des Moduls aufliegt,
   - die elektrischen Kontaktelemente der Kontaktfläche dazu korrespondierende elektrische Kontakte der Leiterplatte und/oder des Moduls elektrisch kontaktieren und
   - der Kontaktor sowohl formschlüssig als auch kraftschlüssig mit der Leiterplatte und/oder dem Modul verbunden wird.

Alternativ kann das Verfahren auch lediglich das Überführen in die erste Montageposition enthalten, bevorzugt zusätzlich noch das Überführen von der ersten in die zweite Montageposition, besonders bevorzugt auch das Überführen von der zweiten in die dritte Montageposition und ganz besonders bevorzugt zusätzlich auch wie aufgelistet sämtliche Montageschritte.

Ein Aspekt betrifft die Verwendung eines Kontaktors gemäß dem eingangs beschriebenen Aspekt zum elektrischen Kontaktieren einer Leiterplatte und/oder eines Moduls.

Im Rahmen dieser Erfindung können die Begriffe "im Wesentlichen" und/oder "etwa" so verwendet sein, dass sie eine Abweichung von bis zu 5% von einem auf den Begriff folgenden Zahlenwert beinhalten, eine Abweichung von bis zu 5° von einer auf den Begriff folgenden Richtung und/oder von einem auf den Begriff folgenden Winkel.

Begriffe wie oben, unten, oberhalb, unterhalb, usw. beziehen sich - sofern nicht anders spezifiziert - auf das Bezugssystem der Erde in einer Betriebsposition des Gegenstands der Erfindung.

Die Erfindung wird nachfolgend anhand von in Figuren gezeigten Ausführungsbeispielen näher beschrieben. Hierbei können gleiche oder ähnliche Bezugszeichen gleiche oder ähnliche Merkmale der Ausführungsformen kennzeichnen. Einzelne in den Figuren gezeigte Merkmale können in anderen Ausführungsbeispielen implementiert sein. Es zeigen:
- Figur 1: in einer perspektivischen Ansicht eine Ausführungsform eines Kontaktors in einer schematischen Darstellung;
- Figur 2: in einer Seitenansicht den Kontaktor in einer schematischen Darstellung;
- Figur 3: in einer Ansicht von unten den Kontaktor in einer schematischen Darstellung;
- Figur 4: in einer Vorderansicht den Kontaktor in einer schematischen Darstellung;
- Figur 5A: in einer perspektivischen Ansicht eine schematische Darstellung einer Ausführungsform eines Kontaktsystems in einem unmontierten Zustand;
- Figur 5B: in einer perspektivischen Ansicht eine schematische Schnittdarstellung des Kontaktsystems in einem zweiten Montagezustand;
- Figur 5C: in einer perspektivischen Ansicht eine schematische Darstellung des Kontaktsystems in einem dritten Montagezustand;
- Figur 5D: in einer perspektivischen Ansicht eine schematische Darstellung des Kontaktsystems in einem vierten, assemblierten Montagezustand;
- Figur 6A: in einer schematischen Darstellung einen Querschnitt durch eine Ausführungsform eines Kontaktors in einem entspannten Zustand; und
- Figur 6B: in einer schematischen Darstellung einen Querschnitt durch den Kontaktor in einem geschlossenen Zustand.

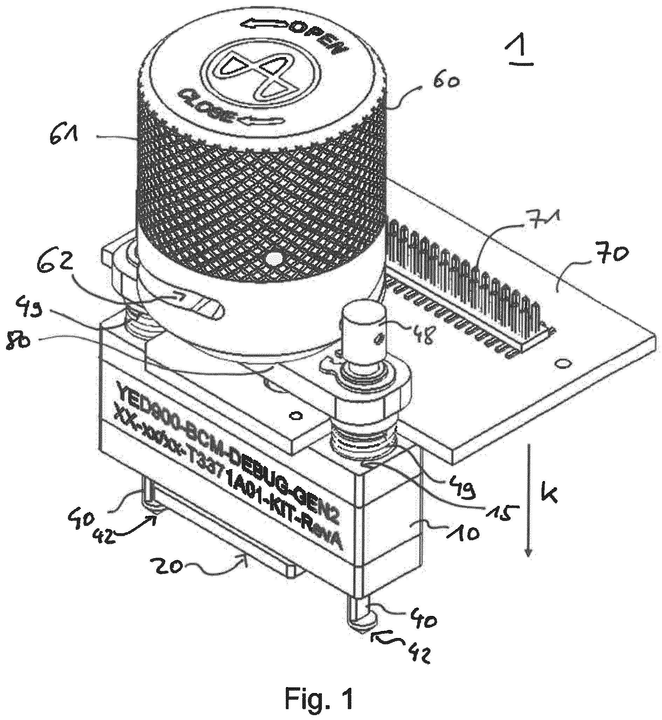

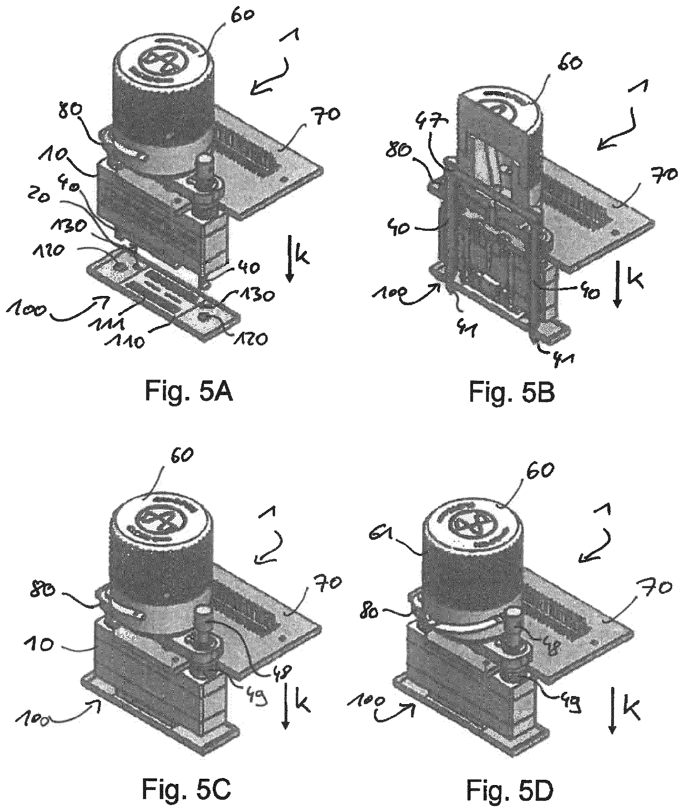

**Figur 1** zeigt in einer perspektivischen Ansicht eine Ausführungsform eines Kontaktors 1 in einer schematischen Darstellung. Der Kontaktor 1 ist dazu ausgebildet und vorgesehen, eine Leiterplatte und/oder ein Modul elektrisch zu kontaktieren. Exemplarisch ist in den Figuren 5A bis 5D gezeigt und nachfolgend beschrieben, wie der Kontaktor 1 eine Leiterplatte 100 kontaktiert. Zunächst ist unter Bezug auf die Figuren 1 bis 4 nur der Kontaktor 1 an sich beschrieben, ohne die zu kontaktierende, in Fig. 5 gezeigte Leiterplatte 100.

Der Kontaktor 1 weist einen Kontaktorkörper 10 auf, welcher zum Beispiel als ein Gehäuse ausgebildet sein kann. Der Kontaktorkörper 10 ist im Ausführungsbeispiel im Wesentlichen quaderförmig ausgebildet. An einer Außenfläche des Kontaktorkörpers 10, im gezeigten Ausführungsbeispiel an seiner Unterseite, weist der Kontaktorkörper 10 eine Kontaktfläche 20 auf. Der Kontaktor 1 ist dazu ausgebildet, mit der Kontaktfläche 20 voran flächig auf die (zum Beispiel in Fig. 5 gezeigte) Leiterplatte 100 aufgesetzt zu werden, um diese elektrisch zu kontaktieren.

Aus derselben Außenfläche des Kontaktorkörpers 10, an der die Kontaktfläche 20 ausgebildet ist, hier aus der Unterseite des Kontaktorkörpers 10, ragen zwei Formschlussmittel 40 aus dem Kontaktorkörper 10 heraus. Die Formschlussmittel 40 sind etwa stiftförmig ausgebildet und durchdringen den Kontaktorkörper 10 vollständig von einem ersten (hier: unteren) Ende, welches benachbart zur Kontaktfläche 20 angeordnet ist, bis zu einem zweiten (hier: oberen) Ende, welches an einer der Kontaktfläche 20 abgewandten Seite des Kontaktorkörpers 10 angeordnet ist.

Die Formschlussmittel 40 sind dabei etwa stiftförmig ausgebildet und im Wesentlichen parallel zur Kontaktrichtung K ausgerichtet und/oder angeordnet. Die Kontaktrichtung K entspricht der Richtung, entlang der die Kontaktfläche 20 auf die (nicht gezeigte) Leiterplatte aufgesetzt wird. Die Kontaktrichtung K kann dabei parallel zu einer Normalen auf die Kontaktfläche 20 ausgerichtet sein und von der Kontaktfläche 20 weg vom Kontaktor 1 nach außen (hier: unten) weisen. Die Formschlussmittel 40 durchdringen den Kontaktorkörper 10 vollständig in Kontaktrichtung K.

An einer Außenfläche des Kontaktorkörpers 10, im Ausführungsbeispiel an dessen Oberseite, welche der Kontaktfläche 20 gegenüberliegend angeordnet ist, ist eine Kontaktorplatte 70 am Kontaktorkörper 10 befestigt. Diese Kontaktorplatte 70 kann zum Beispiel an den Kontaktorkörper 10 angeschraubt sein. Die Kontaktorplatte 70 kann als eine Leiterplatte wie zum Beispiel als eine PCB ausgebildet sein. Die Kontaktorplatte 70 ist dazu ausgebildet, den Kontaktorkörper 10 elektrisch zu kontaktieren, um elektrische Kontakte zu der Kontaktfläche 20 herzustellen. Die Kontaktorplatte 70 ist durch den Kontaktorkörper 10 hindurch an die Kontaktfläche 20 geroutet. An der Kontaktorplatte sind elektrische Anschlusskontakte 71 ausgebildet. Die Anschlusskontakte 71 können derart auf der Kontaktorplatte 70 angeordnet und/oder ausgerichtet sein, dass sie zum Eingehen einer herkömmlichen, z.B. genormten, Steckverbindung mit einem herkömmlichen, z.B. genormten mehrpoligen Steckverbinder wie z.B. einem Busstecker konfiguriert sind.

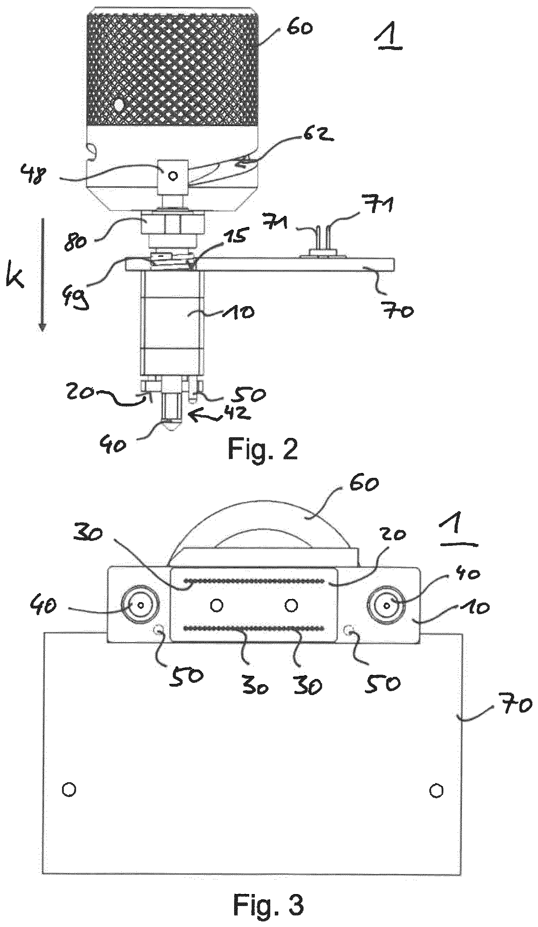

**Figur 2** zeigt den Kontaktor 1 in einer schematischen Seitenansicht. Wie in den Figuren 1 und 2 gezeigt, durchdringen die Formschlussmittel 40 den Kontaktorkörper 10 von benachbart zur Kontaktfläche 20 angeordneten Einsteckbereichen 42 der Formschlussmittel 40 bis zu einer der Kontaktfläche 20 gegenüberliegenden Gegenfläche 15. Die Gegenfläche 15 ist als eine der Kontaktfläche 20 gegenüberliegende Außenfläche des Kontaktorkörpers 10 ausgebildet.

An der Gegenfläche 15 stehen die Formschlussmittel 40 aus dem Kontaktorkörper 10 heraus und sind mit jeweils einem Federmittel 49 versehen, welches eine Federung zwischen der Gegenfläche 15 des Kontaktorkörpers 10 und einer Schraubhalterung 80 bereitstellt. Das Federmittel kann z.B. als eine Schraubfeder ausgebildet sein, welches das stiftartige Formschlussmittel 40 umgibt und sich an der Gegenfläche 15 des Kontaktorkörpers 10 einerseits und an der Schraubhalterung 80 andererseits abstützt.

Die Formschlussmittel 40 durchdringen auch diese Schraubhalterung 80 und weisen an ihrem dem Einsteckbereich 42 gegenüberliegenden Ende jeweils ein Fixierende 48 auf, welches aus der Schraubhalterung 80 herausragt. Am Fixierende 48 kann das Formschlussmittel 40 eine Verbreiterung aufweisen, welche einen Anschlag bereitstellt. Die Verbreiterung am Fixierende 48 kann als ein Aufsatz auf das stiftartige Formschlussmittel 40 ausgebildet sein.

**Figur 3** zeigt den Kontaktor 1 in einer Richtung gegen die Kontaktrichtung K, d.h. hier von unten. Figur 3 zeigt elektrische Kontaktelemente 30, welche aus der Kontaktfläche 20 in Kontaktrichtung K herausragen. Im gezeigten Ausführungsbeispiel sind die elektrischen Kontaktelemente 30 in zwei Reihen angeordnet. Alternativ können die elektrischen Kontaktelemente auch anders angeordnet an der Kontaktfläche 20 sein. Die elektrischen Kontaktelemente 30 sind durch das Innere des Kontaktors 1 hindurch, insbesondere durch das Innere des Kontaktorkörpers 10, mit der Kontaktorplatte 70 elektrisch leitend verbunden. Auf der Kontaktorplatte 70 sind sie geroutet zu den Anschlusskontakten 71, welche z.B. in den Figuren 1 und 2 gezeigt sind. Die Anordnung der elektrischen Kontaktelemente 30 an der Kontaktfläche 20 entspricht dabei einer vorbestimmten Konfiguration, welcher einer Konfiguration von elektrischen Kontakten 111 einer zu kontaktierenden Leiterplatte 100 entspricht (vgl. Fig. 5A).

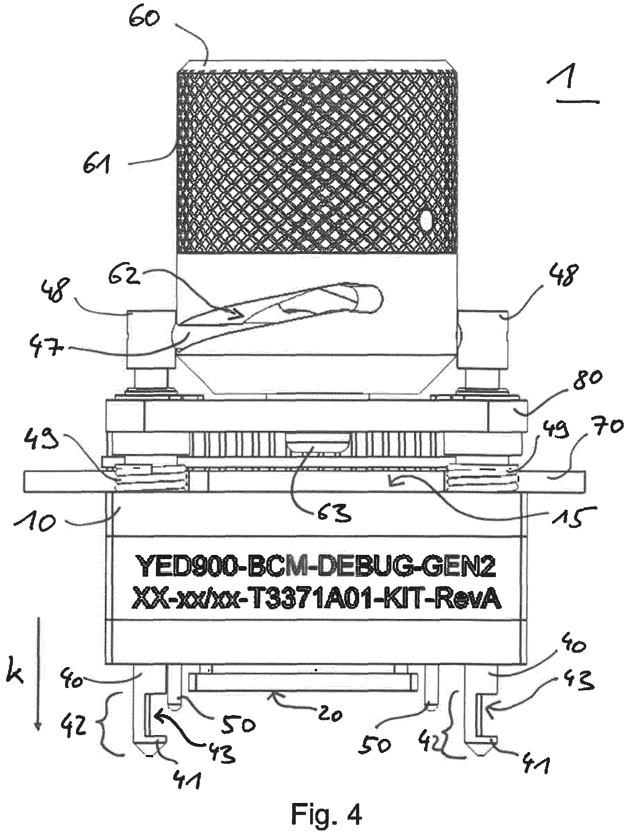

**Figur 4** zeigt den Kontaktor in einer Ansicht in etwa orthogonal zur Kontaktrichtung K, hier in einer Vorderansicht. Figur 4 zeigt, dass die Schraubhalterung 80 als Steg und Verbindung zwischen den beiden Formschlussmitteln 40 ausgebildet und angeordnet ist. Die Schraubhalterung 80 erstreckt sich zwischen beiden Formschlussmitteln 40 in etwa parallel zu den Ebenen der Gegenfläche 15 und/oder der Kontaktfläche 20. Die Schraubhalterung 80 an stegförmig und/oder plattenförmig ausgebildet sein und wird von den Formschlussmitteln 40 vollständig durchdrungen. Die Schraubhalterung 80 und die Formschlussmittel 40 sind so aneinander gelagert, dass die Formschlussmittel 40 relativ zur Schraubhalterung 80 verlagerbar und/oder beweglich sind, und zwar bevorzugt parallel zur Kontaktrichtung K.

Zwischen der Schraubhalterung 80 und der Gegenfläche 15 des Kontaktorkörpers 10 sind jeweils die Federmittel 49 vorgesehen, die die Schraubhalterung 80 gegenüber dem Kontaktorkörper 10 abstützen. Die Federmittel 49 können als Schraubfedern ausgebildet sein, welche die stiftförmigen Formschlussmittel 40 umgeben.

Die Schraubhalterung 80 weist neben den Durchgangsaussparungen für die Formschlussmittel 40 eine weitere Aussparung auf, welche im gezeigten Ausführungsbeispiel als eine zentrale Öffnung ausgebildet ist. Diese zentrale Aussparung ist von einem Schraubmittel 60 des Kontaktors 1 durchdrungen.

Das Schraubmittel 60 weist einen Schraubenfuß 63 auf, welcher durch die zentrale Öffnung in der Schraubhalterung 80 verlaufend angeordnet ist. Der Schraubenfuß 63 weist endseitig eine Verbreiterung auf. Das Schraubmittel 60 ist drehbar an der Schraubhalterung 80 gelagert, im Ausführungsbeispiel drehbar um die Achse der Kontaktrichtung K. Die endseitige Verbreiterung am Schraubenfuß 63 bewirkt eine formschlüssige Befestigung des Schraubmittels 60 an der Schraubhalterung 80.

Das Schraubmittel 60 kann als eine Art Rändelschraube ausgebildet sein, wobei es werkzeuglos mit den Fingern auf und/oder zu geschraubt werden kann. Das Schraubmittel 60 weist kein klassisches externes Schraubengewinde auf, sondern vielmehr eine Schraubausnehmung 62, welche zumindest teilweise durch einen Schraubkopf 61 des Schraubmittels 60 verlaufend ausgebildet ist. Die Schraubausnehmung 62 ist als ein schraubenförmiger Schlitz im und/oder durch den Schraubkopf 61 des Schraubmittels 60 ausgebildet.

Durch die Schraubausnehmung 62 hindurch sind die beiden Fixierenden 48 der beiden Formschlussmittel 40 über eine Verbindung 47 miteinander verbunden. Im Ausführungsbeispiel ist die Verbindung 47 stangenförmig und/oder stiftförmig ausgebildet. Die Verbindung 47 ist etwa orthogonal zur Kontaktrichtung K angeordnet.

Bei einer Verschraubung des Schraubmittels 60 werden die Verbindung 47 und mit ihr die beiden Formschlussmittel 40 in Kontaktrichtung K relativ zur Schraubhalterung 80 und/oder dem Kontaktorkörper 10 verlagert. In Abhängigkeit von der Drehrichtung der Verschraubung kann die Verbindung 47 entweder in Kontaktrichtung K oder gegen die Kontaktrichtung K verlagert werden. Über die Verbindung 47 können sämtliche Formschlussmittel 40 des Kontaktors 1 verbindungssteif und/oder mechanisch aneinander gekoppelt sein. Deswegen kann durch Verlagerung der Verbindung 47 eine Verlagerung sämtlicher Formschlussmittel 40 erfolgen.

In Kontaktrichtung K ragen die Formschlussmittel 40 über die Kontaktfläche 20 aus dem Kontaktorkörper 10 heraus. Dort ist der Einsteckbereich 42 der Formschlussmittel 40 angeordnet, welcher vollständig aus dem Kontaktorkörper 10 in Kontaktrichtung K herausragt. Die Einsteckbereiche 42 sind an den den Fixierenden 48 gegenüberliegenden Enden der Formschlussmittel 40 angeordnet.

Das Formschlussmittel 40 weist am Einsteckbereich 42 eine Lateralausnehmung 43 auf. Die Lateralausnehmung 43 ist als eine Ausnehmung und/oder Verjüngung in einer lateralen Richtung, also in etwa orthogonal zur Kontaktrichtung K, ausgebildet.

Dabei sind die Lateralausnehmungen 43 sämtlicher Einsteckbereiche 42 sämtlicher Formschlussmittel 40 gleichgerichtet ausgebildet, d.h. sie weisen alle mit Ihrer Öffnung in dieselbe laterale Richtung. In der gezeigten Ansicht weisen die Lateralausnehmungen 43 beispielsweise nach rechts.

Am äußersten Ende des Einsteckbereichs 42 in Kontaktrichtung K weist jedes Formschlussmittel 40 einen Lateralsteg 41 auf. Der Lateralsteg 41 steht winklig und/oder etwa orthogonal zur Kontaktrichtung K von dem an der Lateralausnehmung 43 verjüngten Einsteckbereich 42 ab. Dabei kann die Lateralausnehmung 43 nicht vollständig bis an das Ende des Einsteckbereichs 42 in Kontaktrichtung K heranreichend ausgebildet sein, um dort den Lateralsteg 41 auszubilden. Die laterale Ausdehnung und/oder die Stiftdicke (orthogonal zur Kontaktrichtung K) des Formschlussmittels 40 am Einsteckbereich 42 kann vor und nach (hier oberhalb und unterhalb) der Lateralausnehmung 43 etwa gleich dimensioniert sein.

Der Einsteckbereich 42, die Lateralausnehmung 43 und/oder der Lateralsteg 41 ist/sind dazu konfiguriert, eine formschlüssigen Verbindung mit einer Leiterplatte 100 und/oder einem Modul auszubilden.

Der Kontaktor 10 weist weiterhin Führungspins 50 auf, welche in Kontaktrichtung K aus dem Kontaktorkörper 10 herausragen. Im Ausführungsbeispiel weist der Kontaktor 10 exemplarisch genau zwei Führungspins 50 auf, alternativ kann der Kontaktor 10 auch mehr als zwei Führungspins 50 aufweisen.

Die genaue Lage der Führungspins 50 relativ zu den Formschlussmitteln 40 ist in Figur 3 in der Ansicht gegen die Kontaktrichtung K gezeigt. Die Führungspins 50 ragen orthogonal zur Kontaktrichtung K versetzt zu den Formschlussmitteln 40 aus der Außenfläche des Kontaktorkörpers 10 heraus in Kontaktrichtung K.

Wie in Figur 4 gezeigt, ragen die Führungspins 50 in Kontaktrichtung K nicht ganz so weit aus dem Kontaktorkörper 10 heraus wie die Formschlussmittel 40.

Die Kontaktfläche 20 des Kontaktors 1 kann entweder als eine Außenfläche des Kontaktorkörpers 10 ausgebildet sein oder, wie in dem in Fig. 4 gezeigten Ausführungsbeispiel, beabstandet zum Kontaktorkörper 10 und/oder etwa parallel zu dessen in Kontaktrichtung K weisende Außenfläche ausgebildet sein. In der gezeigten Ausführungsform ist die Kontaktfläche 20 als separates Bauteil ausgebildet und relativ zum Kontaktorkörper 10 schwimmend und/oder in Kontaktrichtung K federnd gelagert.

In der in Figur 4 gezeigten Ausführungsform ragen die elektrischen Kontaktelemente 30 nicht aus der Kontaktfläche 20 heraus, zumindest nicht in dem in Fig. 4 gezeigten entspannten Zustand des Kontaktors 1. In dem in Figur 4 gezeigten, entspannten Zustand des Kontaktors 1 sind die elektrischen Kontaktelemente 30 in der Kontaktfläche 20 versenkt angeordnet.

**Figuren 5A bis 5D** zeigen in einer perspektivischen Ansicht, wie das Kontaktsystem bestehend aus dem Kontaktor 1 und der Leiterplatte 100 mechanisch und elektrisch miteinander verbunden wird.

**Figur 5A** zeigt in einer perspektivischen Ansicht einen unmontierten Zustand des Kontaktsystems. Dabei ist der Kontaktor 1 beabstandet von der Leiterplatte 100 angeordnet. Aus diesem unmontierten Zustand wird der Kontaktor 1 mit der Kontaktfläche 20 und den Formschlussmitteln 40 voran in Kontaktrichtung K hin zur Leiterplatte 100 bewegt. Dabei werden die beiden Formschlussmittel 40 in zwei dazu korrespondierende Formschlussmittelaufnahmen 120 eingeführt, welche z.B. als Ausnehmungen und/oder Durchgangslöcher in und/oder durch die Leiterplatte 100 ausgebildet sein können.

Zwischen den beiden Formschlussmittelaufnahmen 120 weist die Leiterplatte 100 eine Anschlussfläche 110 auf, an welcher elektrische Kontakte 111 der Leiterplatte 100 ausgebildet sind. Die elektrischen Kontakte 111 können als offene Kontakte ausgebildet sein und so angeordnet sein, dass sie von den elektrischen Kontaktelementen 30 des Kontaktors 1 kontaktiert werden können (vgl. Figur 3).

Weiterhin sind in der Leiterplatte 100 Führungspinaufnahmen 130 ausgebildet zur Aufnahme der Führungspins 50 (vgl. Figur 4). Beispielsweise weist die Leiterplatte 100 zwei Führungspinaufnahmen 130 auf, die als Bohrlöcher und/oder Aussparungen in der Leiterplatte 100 ausgebildet sein können.

Bei der Montage werden die Formschlussmittel 40 des Kontaktors 1 in die Formschlussmittelaufnahmen 120 der Leiterplatte 100 in Kontaktrichtung K soweit eingeführt, bis kontaktseitige Enden der Führungspins 50 (vgl. Figur 4) auf die dem Kontaktor 1 zugewandte Außenfläche der Leiterplatte 100 und/oder der Anschlussfläche 110 aufsetzen. In diesem ersten Montagezustand kann die Kontaktfläche 20 noch beabstandet von der Anschlussfläche 110 angeordnet sein.

In die erste Montageposition wird der Kontaktors 1 ausschließlich in Kontaktrichtung K bewegt, wobei die Führungspins 50 noch nicht in die Führungspinaufnahmen 130 der Leiterplatte 100 eingefädelt werden. In der ersten Montageposition sind die Führungspins 50 noch lateral und/oder orthogonal zur Kontaktrichtung K versetzt zu den Führungspinaufnahmen 130 auf der Außenfläche der Leiterplatte 100 aufgesetzt. Dabei wirken die kontaktseitigen Enden der Führungspins 50 als Anschlag, der die Bewegungsfreiheit des Kontaktors 1 in Kontaktrichtung K relativ zur Leiterplatte 100 begrenzt. In dem (in den Figuren nicht extra gezeigten) ersten Montagezustand dienen die Führungspins 50 somit als eine Art Anschlag und/oder Abstandshalter für den Kontaktor 1 relativ zur Leiterplatte 100 und/oder einem Modul.

Aus der ersten Montageposition heraus wird der Kontaktor 1 relativ zur Leiterplatte 100 in etwa orthogonal zur Kontaktrichtung K bewegt in diejenige Richtung, in welcher die Lateralausnehmungen 43 offen ausgebildet sind (vgl. Fig. 4). In der in den Figuren 5A und 5B gezeigten Anordnung entspricht dies einer Richtung nach etwa rechts.

**Figur 5B** zeigt in einer perspektivischen Schnittdarstellung einen zweiten Montagezustand, in welchem der Kontaktor 1 gegenüber dem ersten Montagezustand relativ zur Leiterplatte 100 etwas orthogonal zur Kontaktrichtung K versetzt angeordnet ist. Dabei ist die Leiterplatte 100 in die Lateralausnehmungen 43 der Formschlussmittel 40 eingeschoben (vgl. hierzu Figur 4). Die kontaktseitigen Enden der Einsteckbereiche 42 der Formschlussmittel 40 durchstoßen dabei die Leiterplatte 100 vollständig, bis die Lateralstege 41 der Einsteckbereiche 42 (vgl. Figur 4) die Leiterplatte 100 hintergreifen. Damit wird mittels der Formschlussmittel 40 eine in Kontaktrichtung K wirkende, formschlüssige Verbindung zwischen dem Kontaktor 1 und der Leiterplatte 100 ausgebildet.

Der sich so ergebende zweite Montagezustand ist in der in Figur 5B gezeigten Schnittdarstellung gezeigt. In der zweiten Montageposition ist eine formschlüssige Verbindung sowohl parallel zur Kontaktrichtung K als auch orthogonal zur Kontaktrichtung K ausgebildet. Dabei greift die Leiterplatte 100 in die Lateralausnehmungen 43 der Formschlussmittel 40 ein und der Lateralsteg 41 hintergreift die Leiterplatte 100.

In dieser zur ersten Montageposition lateral versetzten zweiten Montageposition sind die Führungspins 50 ausgerichtet mit den Führungspinaufnahmen 130 der Leiterplatte 100 (vgl. auch Figur 5A). Deswegen kann der Kontaktor 1 aus dem zweiten Montagezustand heraus weiter in Kontaktrichtung K auf die Leiterplatte 100 zu bewegt werden. Dabei werden die Führungspins 50 in die Führungspinaufnahmen 130 eingeführt werden, z.B. bis die Kontaktfläche 20 des Kontaktors 1 auf der Anschlussfläche 110 der Leiterplatte 100 aufliegt.

**Figur 5C** zeigt die sich dabei ergebende dritte Montageposition in perspektivischer Darstellung. In der dritten Montageposition ist ein mechanischer Kontakt zwischen der Kontaktfläche 20 des Kontaktors 1 und der Anschlussfläche 110 der Leiterplatte 100 ausgebildet. Weiterhin wirkt ein Formschluss parallel und orthogonal zur Kontaktrichtung K. Der Formschluss kann vorbestimmte Bewegungsspiele in die unterschiedlichen Raumrichtungen erlauben.

**Figur 5D** zeigt in einer perspektivischen Darstellung einen vierten, assemblierten Montagezustand des Kontaktorsystems. Das Kontaktorsystem kann von dem in Figur 5C gezeigten dritten Montagezustand in den in Figur 5D gezeigten vierten Montagezustand übergehen durch Drehung und/oder Verschrauben des Schraubmittels 60. Z.B. kann das Schraubmittel 60 zum Herstellen des assemblierten vierten Montagezustands im Uhrzeigersinn verschraubt werden.

Beim Verschrauben werden die Formschlussmittel 40 relativ zum Kontaktorkörper 10 gegen die Kontaktrichtung K bewegt und/oder verlagert, also in der gezeigten Anordnung nach bspw. oben. In dem in Figur 5D gezeigten vierten Montagezustand sind die Formschlussmittel 40 soweit verlagert, dass sich zusätzlich zu der formschlüssigen Verbindung auch eine kraftschlüssige Verbindung und/oder ein Klemmsitz zwischen dem Kontaktor 1 und der Leiterplatte 100 ergibt. Spätestens in dem vierten assemblierten Montagezustand wird ein elektrischer Kontakt zwischen den elektrischen Kontaktelementen 30 des Kontaktors 1 und den elektrischen Kontakten 111 an der Anschlussfläche 110 der Leiterplatte 100 hergestellt.

Der assemblierte, vierte Montagezustand ist lösbar ausgebildet. Ein Öffnen des verbundenen Kontaktorsystems erfolgt genau andersherum: Beim Öffnen wird zunächst das Schraubmittel 60 in die Gegenrichtung verschraubt, um die kraftschlüssige Verbindung zu lösen und die dritte Montageposition herzustellen. Anschließend wird der Kontaktor 1 gegen die Kontaktrichtung K solange relativ zur Leiterplatte 100 bewegt, bis die Führungspins 50 im Wesentlichen vollständig aus den Führungspinaufnahmen 130 herausgezogen sind. Dabei kann diese Bewegung z.B. durch einen Anschlag der Lateralstege 41 an eine (z.B. in Kontaktrichtung K gerichtete) Außenfläche die Leiterplatte 100 begrenzt sein. Aus dieser zweiten Montageposition heraus wird der Kontaktor 1 orthogonal zur Kontaktrichtung K verlagert, bis die Lateralausnehmungen 43 (in Kontaktrichtung K betrachtet) nicht mehr in Eingriff mit der Leiterplatte 100 stehen. Anschließend können die Einsteckbereiche 42 gegen die Kontaktrichtung K aus den Formschlussmittelaufnahmen 120 bewegt werden, wodurch der Kontaktor 1 vollständig von der Leiterplatte 100 getrennt wird.

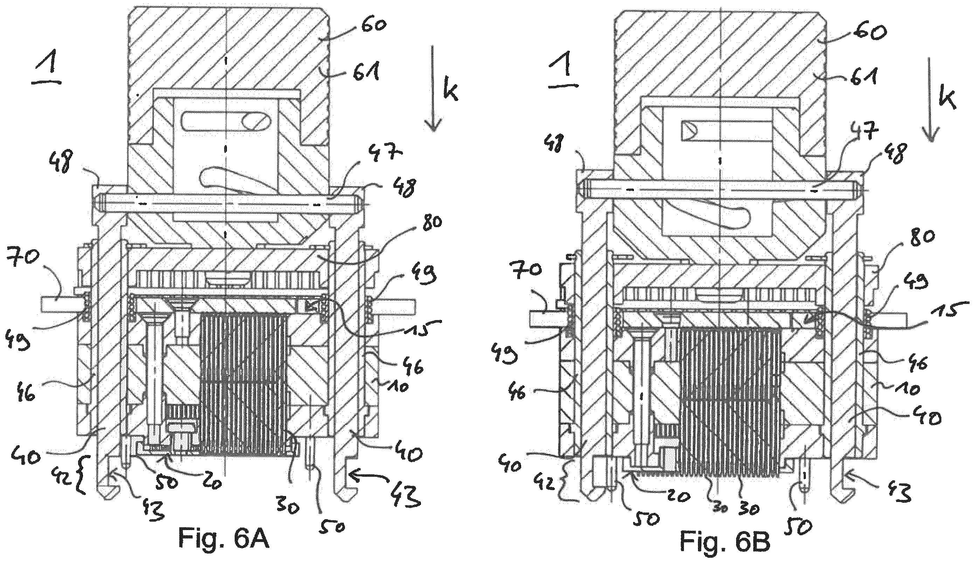

**Figuren 6A und 6B** zeigen in jeweils einer schematischen Darstellung einen Querschnitt durch den Kontaktor 1 in einem entspannten Zustand (Fig. 6A) und in einem geschlossenen Zustand (Fig. 6B). Die Figuren 6A und 6B erlauben einen direkten Vergleich der beiden Zustände des Kontaktors 1. Der Kontaktor 1 nimmt den in Fig. 6B gezeigten geschlossenen Zustand in der vierten, assemblierten Montageposition ein.

In dem geschlossenen, in Figur 6B gezeigten Zustand des Kontaktors 1 ist das Schraubmittel 60 festgeschraubt. Dabei ragen die Formschlussmittel 40 in dem geschlossenen Zustand weniger weit über die Kontaktfläche 20 hinaus als in dem in Figur 6A gezeigten entspannten Zustand. Mit anderen Worten sind bei dem in Figur 6B gezeigten geschlossenen Zustand die Formschlussmittel 40 weiter ins Innere des Kontaktorkörpers 10 zurückgezogen als im offenen Zustand.

Die Bewegung der Formschlussmittel 40 wird bewirkt durch Verlagerung der Verbindung 47, welche quer zur Kontaktrichtung K durch den Schraubkopf 61 hindurch verläuft, gegen die Kontaktrichtung K relativ zur Schraubhalterung 80. Anders gesagt wird beim Verschrauben die Schraubhalterung 80 von der Verbindung 47 in Kontaktrichtung K weg bewegt.

Dabei werden die rückstellfähigen Federmittel 49 zwischen der Schraubhalterung 80 und der Gegenfläche 15 des Kontaktorkörpers 10 gestaucht und die Formschlussmittel 40 werden ins Innere des Kontaktorkörpers 10 hinein verlagert. Zudem werden dabei die elektrischen Kontaktelemente 30 mit ihrem kontaktseitigen Ende aus der Kontaktfläche 20 heraus verlagert, gedrückt und/oder geschoben. Deswegen können die elektrischen Kontaktelemente 30 in dem in Figur 6B gezeigten geschlossenen Zustand des Kontaktors 1 einfach und sicher die offenen elektrischen Kontakte 111 der Leiterplatte 100 kontaktieren (vgl. hierzu auch Figur 5A.

Der Kontaktor 1 ermöglicht ein verbindungssicheres, lösbares elektrisches Kontaktieren der Leiterplatte 100 oder alternativ dazu eines Moduls.

### Bezugszeichenliste

- 1: Kontaktor
- 10: Kontaktorkörper
- 15: Gegenfläche
- 20: Kontaktfläche
- 30: elektrische Kontaktelemente
- 40: Formschlussmittel
- 41: Lateralsteg
- 42: Einsteckbereich
- 43: Lateralausnehmung
- 46: Führung
- 47: Verbindung
- 48: Fixierende
- 49: Federmittel
- 50: Führungspin
- 60: Schraubmittel
- 61: Schraubkopf
- 62: Schraubausnehmung
- 63: Schraubenfuß
- 70: Kontaktorplatte
- 71: Anschlusskontakte
- 80: Schraubhalterung

- 100: Leiterplatte
- 110: Anschlussfläche
- 111: Kontakte
- 120: Formschlussmittelaufnahme
- 121: Auflagefläche
- 130: Führungspinaufnahme

- K: Kontaktrichtung

## Patentansprüche

1. Kontaktor (1) zum elektrischen Kontaktieren einer Leiterplatte (100) und/oder eines Moduls mit
- einem Kontaktorkörper (10), welcher eine Kontaktfläche (20) mit elektrischen Kontaktelementen (30) aufweist,
- zumindest zwei über die Kontaktfläche (20) in eine Kontaktrichtung (K) hervorstehende Formschlussmittel (40) zum Eingehen einer formschlüssigen Verbindung mit der Leiterplatte (100) und/oder dem Modul und
- einem Schraubmittel (60),
wobei
- die Kontaktfläche (20) dazu konfiguriert und ausgebildet ist, in Kontaktrichtung (K) einen mechanischen Kontakt mit einer Anschlussfläche (110) der Leiterplatte (100) und/oder des Moduls derart einzugehen, dass die elektrischen Kontaktelemente (30) der Kontaktfläche (20) dazu korrespondierende elektrische Kontakte (111) der Leiterplatte (100) und/oder des Moduls elektrisch kontaktieren,
- die Formschlussmittel (40) relativ zur Kontaktfläche (20) beweglich an dem Kontaktor (1) gelagert sind,
- sämtliche Formschlussmittel (40) so aneinander und/oder an das Schraubmittel (60) gekoppelt sind, dass sie durch Betätigung des Schraubmittels (60) synchron zueinander relativ zur Kontaktfläche (20) verlagerbar sind, und
- die Formschlussmittel (40) relativ zur Kontaktfläche (20) und/oder zum Kontaktorkörper (10) in Kontaktrichtung (K) beweglich ausgebildet sind.

2. Kontaktor (1) nach Anspruch 1, wobei die Formschlussmittel (40) in einer Führungsausnehmung durch den Kontaktorkörper (10) beweglich gelagert sind.

3. Kontaktor (1) nach einem der vorangegangenen Ansprüche, wobei die Formschlussmittel (40) jeweils einen Einsteckbereich (42) aufweisen, der jeweils dazu ausgebildet ist, in eine Formschlussmittelaufnahme (120) der Leiterplatte (100) und/oder des Moduls einzugreifen.

4. Kontaktor (1) nach Anspruch 3, wobei die Formschlussmittel (40) am Einsteckbereich (42) einen Lateralsteg (41) aufweisen, welcher etwa orthogonal zur Kontaktrichtung (K) ausgebildet ist, wobei der Lateralsteg (41) optional dazu ausgebildet ist, eine dem Kontaktor (1) abgewandte Auflagefläche an der Formschlussmittelaufnahme (120) der Leiterplatte (100) und/oder des Moduls zu hintergreifen.

5. Kontaktor (1) nach einem der vorangegangenen Ansprüche, wobei die Formschlussmittel (40) dazu ausgebildet sind, eine formschlüssige Verbindung mit der Leiterplatte (100) und/oder dem Modul derart einzugehen, dass durch Verlagerung des Formschlussmittels (40) relativ zur Kontaktfläche (20) eine kraftschlüssige Verbindung zwischen der Kontaktfläche (20) und der Anschlussfläche (120) der Leiterplatte (100) und/oder des Moduls bereitgestellt wird.

6. Kontaktor (1) nach einem der vorangegangenen Ansprüche, mit zumindest einem Führungspin (50), welcher in Kontaktrichtung (K) über die Kontaktfläche (20) hervorsteht, wobei optional das Formschlussmittel (40) in Kontaktrichtung (K) weiter über die Kontaktfläche (20) hervorsteht als der Führungspin (50).

7. Kontaktor (1) nach Anspruch 6, wobei der Führungspin (50) derart konfiguriert ist, dass der Führungspin (50) beim Herstellen einer elektrischen Kontaktierung zwischen dem Kontaktor (1) und der Leiterplatte (100) und/oder dem Modul in einer ersten Montageposition als ein Anschlag wirkt, und der Führungspin (50) in einer zweiten Montageposition unter Eingriff in zumindest eine Führungspinaufnahme (130) der Leiterplatte (100) und/oder des Moduls eine vorbestimmte Positionierung des Kontaktors (1) relativ zur Leiterplatte (100) und/oder dem Modul unterstützt.

8. Kontaktor (1) nach einem der vorangegangenen Ansprüche, wobei die Formschlussmittel (40) derart konfiguriert sind, dass der Kontaktor (1) durch eine Bewegung des Kontaktors (1) relativ zur Leiterplatte (100) und/oder zum Modul in etwa in Kontaktrichtung (K) in eine erste Montageposition bringbar ist, in welcher die Formschlussmittel (40) in eine Formschlussmittelaufnahme (120) der Leiterplatte (100) und/oder des Moduls eingreifen, wobei optional die Formschlussmittel (40) derart konfiguriert sind, dass der Kontaktor (1) durch eine Bewegung des Kontaktors (1) relativ zur Leiterplatte (100) und/oder zum Modul in etwa orthogonal zur Kontaktrichtung (K) von der ersten Montageposition in eine zweite Montageposition bringbar ist, in welcher die Formschlussmittel (40) in die Formschlussmittelaufnahme (120) der Leiterplatte (100) und/oder des Moduls eingreifen.

9. Kontaktor (1) nach Anspruch 8, wobei die Formschlussmittel (40) derart konfiguriertsind, dass der Kontaktor (1) durch eine Bewegung des Kontaktors (1) relativ zur Leiterplatte (100) und/oder zum Modul in etwa in Kontaktrichtung (K) von der zweiten Montageposition in eine dritte Montageposition bringbar ist, in welcher die Formschlussmittel (40) in die Formschlussmittelaufnahme (120) der Leiterplatte (100) und/oder des Moduls eingreifen und in welcher die Kontaktfläche (20) des Kontaktors (1) auf der Anschlussfläche (110) der Leiterplatte (100) und/oder des Moduls aufliegt, wobei optional die Formschlussmittel (40) derart konfiguriertsind, dass der Kontaktor (1) durch eine Bewegung des Formschlussmittels (40) relativ zur Kontaktfläche (20) in etwa gegen die Kontaktrichtung (K) von der dritten Montageposition in eine vierte Montageposition bringbar ist, in welcher:
- die Formschlussmittel (40) in die Formschlussmittelaufnahme (120) der Leiterplatte (100) und/oder des Moduls eingreifen,
- die Kontaktfläche (20) des Kontaktors (1) auf der Anschlussfläche (110) der Leiterplatte (100) und/oder des Moduls aufliegt,
- die elektrischen Kontaktelemente (30) der Kontaktfläche (20) dazu korrespondierende elektrische Kontakte (111) der Leiterplatte (100) und/oder des Moduls elektrisch kontaktieren und
- der Kontaktor (1) sowohl formschlüssig als auch kraftschlüssig mit der Leiterplatte (100) und/oder dem Modul verbunden ist.

10. Kontaktorsystem mit einem Kontaktor (1) nach einem der vorangegangenen Ansprüche und einer Leiterplatte (100) und/oder einem Modul mit zumindest einer Formschlussmittelaufnahme (120) zur Aufnahme des zumindest einen Formschlussmittels (40) des Kontaktors (1) derart, dass der Kontaktor (1) mit der Leiterplatte (100) und/oder dem Modul so verbunden ist, dass die elektrischen Kontaktelemente (30) der Kontaktfläche (20) die dazu korrespondierenden elektrischen Kontakte (111) der Leiterplatte (100) und/oder des Moduls elektrisch kontaktieren.

11. Verfahren zum elektrischen Kontaktieren einer Leiterplatte (100) und/oder eines Moduls mit den Schritten:
- Bereitstellen eines Kontaktors (1) nach einem der Ansprüche 1-9 mit einem Kontaktorkörper (10), welcher eine Kontaktfläche (20) mit elektrischen Kontaktelementen (30) aufweist, und mit einem Schraubmittel (60);
- Bewegen eines Formschlussmittels (40) des Kontaktors (1), welches in eine Kontaktrichtung (K) über die Kontaktfläche (20) hervorsteht, relativ zur Kontaktfläche (20) derart, dass der Kontaktor (1) eine formschlüssige Verbindung mit der Leiterplatte (100) und/oder dem Modul eingeht;
wobei
- die Kontaktfläche (20) in Kontaktrichtung (K) einen mechanischen Kontakt mit einer Anschlussfläche der Leiterplatte (100) und/oder des Moduls derart eingeht, dass die elektrischen Kontaktelemente (30) der Kontaktfläche (20) dazu korrespondierende elektrische Kontakte (111) der Leiterplatte (100) und/oder des Moduls elektrisch kontaktieren,
- sämtliche Formschlussmittel (40) so aneinander und/oder an das Schraubmittel (60) gekoppelt sind, dass sie durch Betätigung des Schraubmittels (60) synchron zueinander relativ zur Kontaktfläche (20) verlagert werden und
- die Formschlussmittel (40) relativ zur Kontaktfläche (20) und/oder zum Kontaktorkörper (10) in Kontaktrichtung (K) bewegt werden.

12. Verfahren nach Anspruch 11 mit den Schritten:
- Bewegen des Kontaktors (1) relativ zur der Leiterplatte (100) und/oder zum Modul in eine erste Montageposition in etwa in Kontaktrichtung (K), wobei die Formschlussmittel (40) in eine Formschlussmittelaufnahme (120) der Leiterplatte (100) und/oder des Moduls eingreifen;
- Bewegen des Kontaktors (1) relativ zu der Leiterplatte (100) und/oder zum Modul in etwa orthogonal zur Kontaktrichtung (K) von der ersten Montageposition in eine zweite Montageposition, wobei die Formschlussmittel (40) weiterhin in die Formschlussmittelaufnahme (120) der Leiterplatte (100) und/oder des Moduls eingreifen;
- Bewegen des Kontaktors (1) relativ zur Leiterplatte (100) und/oder zum Modul in etwa in Kontaktrichtung (K) von der zweiten Montageposition in eine dritte Montageposition, wobei die Formschlussmittel (40) weiterhin in die Formschlussmittelaufnahme (120) der Leiterplatte (100) und/oder des Moduls eingreifen und soweit bis die Kontaktfläche (20) des Kontaktors (1) auf der Anschlussfläche (110) der Leiterplatte (100) und/oder des Moduls aufliegt; und
- Bewegen der Formschlussmittels (40) relativ zur Kontaktfläche (20) in etwa gegen die Kontaktrichtung (K) von der dritten Montageposition in eine vierte Montageposition, wobei
- die Formschlussmittel (40) weiterhin in die Formschlussmittelaufnahme (120) der Leiterplatte (100) und/oder des Moduls eingreifen,
- die Kontaktfläche (20) des Kontaktors (1) weiterhin auf der Anschlussfläche (110) der Leiterplatte (100) und/oder des Moduls aufliegt,
- die elektrischen Kontaktelemente (30) der Kontaktfläche (20) dazu korrespondierende elektrische Kontakte (111) der Leiterplatte (100) und/oder des Moduls elektrisch kontaktieren und
- der Kontaktor (1) sowohl formschlüssig als auch kraftschlüssig mit der Leiterplatte (100) und/oder dem Modul verbunden wird.

13. Verwendung eines Kontaktors (1) nach einem der Ansprüche 1 bis 9 zum elektrischen Kontaktieren einer Leiterplatte (100) und/oder eines Moduls.

## Claims

1. Contactor (1) for electrically contacting a printed circuit board (100) and/or a module, comprising
- a contactor body (10) having a contact surface (20) with electrical contact elements (30),
- at least two positive-locking means (40) projecting beyond the contact surface (20) in a contact direction (K) for establishing a positive-locking connection with the printed circuit board (100) and/or the module, and
- a screw element (60),
wherein
- the contact surface (20) is configured and designed to make mechanical contact, in the contact direction (K), with a connection surface (110) of the printed circuit board (100) and/or the module in such a manner that the electrical contact elements (30) of the contact surface (20) electrically contact corresponding electrical contacts (111) of the printed circuit board (100) and/or the module,
- the positive-locking means (40) are movably mounted on the contactor (1) relative to the contact surface (20),
- all positive-locking means (40) are coupled to one another and/or to the screw element (60) in such a manner that they can be displaced synchronously with one another relative to the contact surface (20) by actuation of the screw element (60), and
- the positive-locking means (40) are configured to be movable relative to the contact surface (20) and/or the contactor body (10) in the contact direction (K).

2. Contactor (1) according to claim 1, wherein the positive-locking means (40) are movably mounted in a guide recess extending through the contactor body (10).

3. Contactor (1) according to any one of the preceding claims, wherein the positive-locking means (40) each have an insertion portion (42), each of which is configured to engage in a positive-locking-means receptacle (120) of the printed circuit board (100) and/or the module.

4. Contactor (1) according to claim 3, wherein the positive-locking means (40) have, at the insertion portion (42), a lateral web (41) extending approximately orthogonally to the contact direction (K), wherein the lateral web (41) is optionally configured to engage behind a bearing surface of the positive-locking-means receptacle (120) of the printed circuit board (100) and/or the module, said bearing surface facing away from the contactor (1).

5. Contactor (1) according to any one of the preceding claims, wherein the positive-locking means (40) are configured to establish a positive-locking connection with the printed circuit board (100) and/or the module in such a manner that, by displacement of the positive-locking means (40) relative to the contact surface (20), a force-locking connection is provided between the contact surface (20) and the connection surface (120) of the printed circuit board (100) and/or the module.

6. Contactor (1) according to any one of the preceding claims, comprising at least one guide pin (50) projecting beyond the contact surface (20) in the contact direction (K), wherein, optionally, the positive-locking means (40) project farther beyond the contact surface (20) in the contact direction (K) than the guide pin (50).

7. Contactor (1) according to claim 6, wherein the guide pin (50) is configured in such a manner that, when electrical contact is established between the contactor (1) and the printed circuit board (100) and/or the module, the guide pin (50) acts as a stop in a first mounting position, and, in a second mounting position, the guide pin (50), by engaging in at least one guide-pin receptacle (130) of the printed circuit board (100) and/or the module, assists in a predetermined positioning of the contactor (1) relative to the printed circuit board (100) and/or the module.

8. Contactor (1) according to any one of the preceding claims, wherein the positive-locking means (40) are configured in such a manner that the contactor (1) can be brought, by moving the contactor (1) relative to the printed circuit board (100) and/or the module approximately in the contact direction (K), into a first mounting position in which the positive-locking means (40) engage in a positive-locking-means receptacle (120) of the printed circuit board (100) and/or the module, wherein, optionally, the positive-locking means (40) are configured in such a manner that the contactor (1) can be brought, by moving the contactor (1) relative to the printed circuit board (100) and/or the module approximately orthogonally to the contact direction (K), from the first mounting position into a second mounting position in which the positive-locking means (40) engage in the positive-locking-means receptacle (120) of the printed circuit board (100) and/or the module.

9. Contactor (1) according to claim 8, wherein the positive-locking means (40) are configured in such a manner that the contactor (1) can be brought, by moving the contactor (1) relative to the printed circuit board (100) and/or the module approximately in the contact direction (K), from the second mounting position into a third mounting position in which the positive-locking means (40) engage in the positive-locking-means receptacle (120) of the printed circuit board (100) and/or the module and in which the contact surface (20) of the contactor (1) rests on the connection surface (110) of the printed circuit board (100) and/or the module, wherein, optionally, the positive-locking means (40) are configured in such a manner that the contactor (1) can be brought, by moving the positive-locking means (40) relative to the contact surface (20) approximately opposite to the contact direction (K), from the third mounting position into a fourth mounting position in which:
- the positive-locking means (40) engage in the positive-locking-means receptacle (120) of the printed circuit board (100) and/or the module,
- the contact surface (20) of the contactor (1) rests on the connection surface (110) of the printed circuit board (100) and/or the module,
- the electrical contact elements (30) of the contact surface (20) electrically contact corresponding electrical contacts (111) of the printed circuit board (100) and/or the module, and
- the contactor (1) is connected to the printed circuit board (100) and/or the module by both a positive-locking connection and a force-locking connection.

10. Contactor system comprising a contactor (1) according to any one of the preceding claims and a printed circuit board (100) and/or a module having at least one positive-locking-means receptacle (120) for receiving the at least one positive-locking means (40) of the contactor (1) in such a manner that the contactor (1) is connected to the printed circuit board (100) and/or the module such that the electrical contact elements (30) of the contact surface (20) electrically contact the corresponding electrical contacts (111) of the printed circuit board (100) and/or the module.

11. Method for electrically contacting a printed circuit board (100) and/or a module, comprising the steps of:
- providing a contactor (1) according to any one of claims 1-9, having a contactor body (10) which has a contact surface (20) with electrical contact elements (30), and having a screw element (60);
- moving a positive-locking means (40) of the contactor (1), which projects beyond the contact surface (20) in a contact direction (K), relative to the contact surface (20) in such a manner that the contactor (1) establishes a positive-locking connection with the printed circuit board (100) and/or the module;
wherein
- the contact surface (20) makes mechanical contact, in the contact direction (K), with a connection surface of the printed circuit board (100) and/or the module in such a manner that the electrical contact elements (30) of the contact surface (20) electrically contact corresponding electrical contacts (111) of the printed circuit board (100) and/or the module,
- all positive-locking means (40) are coupled to one another and/or to the screw element (60) in such a manner that they are displaced synchronously with one another relative to the contact surface (20) by actuation of the screw element (60), and
- the positive-locking means (40) are moved relative to the contact surface (20) and/or the contactor body (10) in the contact direction (K).

12. Method according to claim 11, comprising the steps of:
- moving the contactor (1) relative to the printed circuit board (100) and/or the module approximately in the contact direction (K) into a first mounting position, wherein the positive-locking means (40) engage in a positive-locking-means receptacle (120) of the printed circuit board (100) and/or the module;
- moving the contactor (1) relative to the printed circuit board (100) and/or the module approximately orthogonally to the contact direction (K) from the first mounting position into a second mounting position, wherein the positive-locking means (40) continue to engage in the positive-locking-means receptacle (120) of the printed circuit board (100) and/or the module;
- moving the contactor (1) relative to the printed circuit board (100) and/or the module approximately in the contact direction (K) from the second mounting position into a third mounting position, wherein the positive-locking means (40) continue to engage in the positive-locking-means receptacle (120) of the printed circuit board (100) and/or the module, and continuing the movement until the contact surface (20) of the contactor (1) rests on the connection surface (110) of the printed circuit board (100) and/or the module; and
- moving the positive-locking means (40) relative to the contact surface (20) approximately opposite to the contact direction (K) from the third mounting position into a fourth mounting position, wherein
- the positive-locking means (40) continue to engage in the positive-locking-means receptacle (120) of the printed circuit board (100) and/or the module,
- the contact surface (20) of the contactor (1) continues to rest on the connection surface (110) of the printed circuit board (100) and/or the module,
- the electrical contact elements (30) of the contact surface (20) electrically contact corresponding electrical contacts (111) of the printed circuit board (100) and/or the module, and
- the contactor (1) is connected to the printed circuit board (100) and/or the module by both a positive-locking connection and a force-locking connection.

13. Use of a contactor (1) according to any one of claims 1 to 9 for electrically contacting a printed circuit board (100) and/or a module.

## Revendications

1. Un contacteur (1) destiné à établir un contact électrique avec une carte de circuit imprimé (100) et/ou un module, comprenant :
- un corps de contacteur (10) lequel présente une surface de contact (20) comportant des éléments de contact électriques (30),
- au moins deux moyens à engagement positif (40) faisant saillie au-delà de la surface de contact (20) dans une direction de contact (K) afin d'établir une liaison à engagement positif avec la carte de circuit imprimé (100) et/ou le module, et
- un moyen de vissage (60),
sachant que
- la surface de contact (20) est configurée et réalisée pour établir, dans la direction de contact (K), un contact mécanique avec une surface de raccordement (110) de la carte de circuit imprimé (100) et/ou du module, de manière que les éléments de contact électriques (30) de la surface de contact (20) établissent un contact électrique avec des contacts électriques correspondants (111) de la carte de circuit imprimé (100) et/ou du module,
- les moyens à engagement positif (40) sont montés sur le contacteur (1) de manière mobile par rapport à la surface de contact (20),
- tous les moyens à engagement positif (40) sont couplés les uns aux autres et/ou au moyen de vissage (60) de manière qu'ils puissent être déplacés simultanément les uns par rapport aux autres par rapport à la surface de contact (20) par actionnement du moyen de vissage (60), et que
- les moyens à engagement positif (40) sont réalisés pour être mobiles par rapport à la surface de contact (20) et/ou au corps de contacteur (10) dans la direction de contact (K).

2. Le contacteur (1) d'après la revendication 1, sachant que les moyens à engagement positif (40) sont montés de manière mobile dans un évidement de guidage traversant le corps de contacteur (10).

3. Le contacteur (1) d'après l'une des revendications précédentes, sachant que les moyens à engagement positif (40) comportent chacun une zone d'insertion (42) qui est réalisée respectivement de manière à s'engager dans un logement de moyens à engagement positif (120) de la carte de circuit imprimé (100) et/ou du module.

4. Le contacteur (1) d'après la revendication 3, sachant que les moyens à engagement positif (40) comportent, au niveau de la zone d'insertion (42), une nervure latérale (41) qui est réalisée de manière approximativement orthogonale à la direction de contact (K), sachant que la nervure latérale (41) est facultativement réalisée pour venir en prise derrière une surface d'appui tournée à l'opposé du contacteur (1), au niveau du logement de moyens à engagement positif (120) de la carte de circuit imprimé (100) et/ou du module.

5. Le contacteur (1) d'après l'une des revendications précédentes, sachant que les moyens à engagement positif (40) sont réalisés pour établir une liaison à engagement positif avec la carte de circuit imprimé (100) et/ou du module, de telle manière que par le déplacement du moyen à engagement positif (40) par rapport à la surface de contact (20) une liaison par adhérence entre la surface de contact (20) et la surface de raccordement (120) de la carte de circuit imprimé (100) et/ou du module soit réalisée.

6. Le contacteur (1) d'après l'une des revendications précédentes, comportant au moins une broche de guidage (50) qui fait saillie au-delà de la surface de contact (20) dans la direction de contact (K), le moyen à engagement positif (40) faisant, de manière optionnelle, saillie au-delà de la surface de contact (20) dans la direction de contact (K) davantage que la broche de guidage (50).

7. Le contacteur (1) d'après la revendication 6, sachant que la broche de guidage (50) est configurée de manière que, lors de l'établissement d'un contact électrique entre le contacteur (1) et la carte de circuit imprimé (100) et/ou le module, la broche de guidage (50) agit comme une butée dans une première position de montage, et que dans une deuxième position de montage, la broche de guidage (50), en s'engageant dans au moins un logement de broche de guidage (130) de la carte de circuit imprimé (100) et/ou du module, favorise un positionnement prédéterminé du contacteur (1) par rapport à la carte de circuit imprimé (100) et/ou au module.

8. Le contacteur (1) d'après l'une des revendications précédentes, sachant que les moyens à engagement positif (40) sont configurés de telle manière que le contacteur (1) puisse être amené, par un mouvement du contacteur (1) par rapport à la carte de circuit imprimé (100) et/ou au module, approximativement dans la direction de contact (K), dans une première position de montage, dans laquelle les moyens à engagement positif (40) s'engagent dans un logement de moyens à engagement positif (120) de la carte de circuit imprimé (100) et/ou du module, sachant que, facultativement, les moyens à engagement positif (40) peuvent être configurés de telle manière que le contacteur (1) puisse être amené, par un mouvement du contacteur (1) par rapport à la carte de circuit imprimé (100) et/ou au module, approximativement orthogonalement à la direction de contact (K), de la première position de montage vers une deuxième position de montage, dans laquelle les moyens à engagement positif (40) s'engagent dans le logement de moyens à engagement positif (120) de la carte de circuit imprimé (100) et/ou du module.

9. Le contacteur (1) d'après la revendication 8, sachant que les moyens à engagement positif (40) sont configurés de telle manière que le contacteur (1) puisse être amené, par un mouvement du contacteur (1) par rapport à la carte de circuit imprimé (100) et/ou au module, approximativement dans la direction de contact (K), de la deuxième position de montage vers une troisième position de montage, dans laquelle les moyens à engagement positif (40) s'engagent dans le logement de moyens à engagement positif (120) de la carte de circuit imprimé (100) et/ou du module, et dans laquelle la surface de contact (20) du contacteur (1) repose sur la surface de raccordement (110) de la carte de circuit imprimé (100) et/ou du module, sachant que, facultativement, les moyens à engagement positif (40) sont configurés de telle manière que le contacteur (1) puisse être amené, par un mouvement du moyen à engagement positif (40) par rapport à la surface de contact (20), approximativement dans le sens opposé à la direction de contact (K), de la troisième position de montage vers une quatrième position de montage, dans laquelle :
- les moyens à engagement positif (40) s'engagent dans le logement de moyens à engagement positif (120) de la carte de circuit imprimé (100) et/ou du module,
- la surface de contact (20) du contacteur (1) repose sur la surface de raccordement (110) de la carte de circuit imprimé (100) et/ou du module,
- les éléments de contact électriques (30) de la surface de contact (20) établissent un contact électrique avec des contacts électriques correspondants (111) de la carte de circuit imprimé (100) et/ou du module, et
- le contacteur (1) est relié à la carte de circuit imprimé (100) et/ou au module à la fois par liaison à engagement positif et par liaison par adhérence.

10. Un système de contacteur comprenant un contacteur (1) d'après l'une des revendications précédentes et une carte de circuit imprimé (100) et/ou un module comportant au moins un logement de moyens à engagement positif (120) destiné à loger le ou les moyens à engagement positif (40) du contacteur (1), de telle manière que le contacteur (1) soit relié à la carte de circuit imprimé (100) et/ou au module de telle manière que les éléments de contact électriques (30) de la surface de contact (20) établissent un contact électrique avec les contacts électriques correspondants (111) de la carte de circuit imprimé (100) et/ou du module.

11. Un procédé de mise en contact électrique d'un circuit imprimé (100) et/ou d'un module, comprenant les étapes suivantes :
- mise à disposition d'un contacteur (1) d'après l'une des revendications de 1 à 9, comportant un corps de contacteur (10) qui présente une surface de contact (20) avec des éléments de contact électriques (30), et un moyen de vissage (60) ;
- le déplacement, par rapport à la surface de contact (20), d'un moyen à engagement positif (40) du contacteur (1), qui fait saillie dans une direction de contact (K) au-delà de la surface de contact (20), de telle manière que le contacteur (1) établisse une liaison à engagement positif avec la carte de circuit imprimé (100) et/ou le module ;
sachant que
- la surface de contact (20) établit, dans la direction de contact (K), un contact mécanique avec une surface de raccordement de la carte de circuit imprimé (100) et/ou du module, de telle manière que les éléments de contact électriques (30) de la surface de contact (20) établissent un contact électrique avec les contacts électriques correspondants (111) de la carte de circuit imprimé (100) et/ou du module,
- tous les moyens à engagement positif (40) sont couplés les uns aux autres et/ou au moyen de vissage (60) de telle manière qu'ils soient déplacés de manière synchrone les uns par rapport aux autres par rapport à la surface de contact (20) par actionnement du moyen de vissage (60), et que
- les moyens à engagement positif (40) sont déplacés par rapport à la surface de contact (20) et/ou au corps du contacteur (10) dans la direction de contact (K).

12. Le procédé d'après la revendication 11, comprenant les étapes suivantes :
- le déplacement du contacteur (1) par rapport à la carte de circuit imprimé (100) et/ou au module vers une première position de montage approximativement dans la direction de contact (K), sachant que les moyens à engagement positif (40) s'engagent dans un logement de moyens à engagement positif (120) de la carte de circuit imprimé (100) et/ou du module ;
- le déplacement du contacteur (1) par rapport à la carte de circuit imprimé (100) et/ou au module, approximativement orthogonalement à la direction de contact (K), de la première position de montage vers une deuxième position de montage, sachant que les moyens à engagement positif (40) restent engagés dans le logement de moyens à engagement positif (120) de la carte de circuit imprimé (100) et/ou du module ;
- le déplacement du contacteur (1) par rapport à la carte de circuit imprimé (100) et/ou au module, approximativement dans la direction de contact (K), de la deuxième position de montage vers une troisième position de montage, sachant que les moyens à engagement positif (40) restent engagés dans le logement de moyens à engagement positif (120) de la carte de circuit imprimé (100) et/ou du module, et ce jusqu'à ce que la surface de contact (20) du contacteur (1) repose sur la surface de raccordement (110) de la carte de circuit imprimé (100) et/ou du module ; et
- le déplacement des moyens à engagement positif (40) par rapport à la surface de contact (20), approximativement dans le sens opposé à la direction de contact (K), de la troisième position de montage vers une quatrième position de montage, sachant que
- les moyens à engagement positif (40) restent engagés dans le logement de moyens à engagement positif (120) de la carte de circuit imprimé (100) et/ou du module,
- la surface de contact (20) du contacteur (1) repose toujours sur la surface de raccordement (110) de la carte de circuit imprimé (100) et/ou du module,
- les éléments de contact électriques (30) de la surface de contact (20) établissent un contact électrique avec des contacts électriques correspondants (111) de la carte de circuit imprimé (100) et/ou du module, et
- le contacteur (1) est relié à la carte de circuit imprimé (100) et/ou au module à la fois par liaison à engagement positif et par liaison par adhérence.

13. Une utilisation d'un contacteur (1) d'après l'une des revendications de 1 à 9 pour établir un contact électrique avec une carte de circuit imprimé (100) et/ou un module.
